# EUROPEAN PATENT SPECIFICATION

(11) **EP 0 915 189 B1**
(45) Date of publication and mention of the grant of the patent: **08.10.2003**
(21) Application number: 98304973.5
(22) Date of filing: 24.06.1998
(51) Int. Cl.: C25D 17/00, H05K 3/24, C25D 17/06

(54) **An electroplating apparatus**
Elektroplattierungsanlage
Appareil de galvanoplastie

(30) Priority: 07.10.1997 GB 9721245; 19.05.1998 GB 9810764
(43) Date of publication of application: 12.05.1999
(73) Proprietor: PROCESS AUTOMATION INTERNATIONAL LIMITED, Tai Po, New Territories (HK)
(72) Inventor: Henington, Paul, Tai Po, New Territories, Hong Kong (CN); Fung, Chun Pan, Tai Po, New Territories, Hong Kong (CN); Li, Kwok Wah, Tai Po, New Territories, Hong Kong (CN); Lee, Chi Chung, Tai Po, New Territories, Hong Kong (CN)
(74) Representative: Findlay, Alice Rosemary

(56) References cited:
- EP-A- 0 666 343
- DE-A- 4 005 209
- DE-C- 3 726 571

## Description

This invention relates to an electroplating apparatus and is, in particular, concerned with such an apparatus with improvements in the uniform distribution of metal on substrates to be electroplated, e.g. printed circuit boards.

US Patent No. 4,879,007 discloses a floating shield for use in an electrolytic bath. The shield includes an elongated trough in which substrates are loaded for plating. The substrates are held in the trough in a vertical plane, and with the lower edges of the substrates below the plane of the upper edges of the trough. Immersed into the bath are a pair of anodes, each extending parallel to the longitudinal axis of the floating shield. The substrates loaded in the trough are connected to a cathode bus bar by one or more clamps. In operation, electric current passes between the anodes and the cathode bus bar through electrolyte contained in the bath, and thereby to electroplate the substrates.

German Patent Document No. DE 37 26 571 C discloses a screening and positioning frame for printed-circuit boards in hot-dip galvanishing installations, which has a panel in the form of a roof with the ridge pointing downwards, and is guided in the vertical direction by laterally attached lugs in vertical slits of a securing means. In the basic position, the panel is on the surface of the bath. The substrates to be electroplated are positioned in the panel. High current densities at the edge of the board are avoided and precise positioning in the electroplating bath is facilitated.

When a plating factory orders an electroplating apparatus from a manufacturer, it is necessary to specify the "board size" of the substrates intended to be plated by the apparatus. In this connection, "board size" means the vertical length of the substrate when such is held in a vertical plane. It is also a usual practice in the relevant field to so arrange the depth of the floating shield in the bath that the top edge of the substrates is of a fixed distance from the top edge of the bath. The manufacturer will then arrange the dimensions of the bath, the anodes and the depth of the trough in the bath such that there will be a satisfactory and uniform electroplating result. It is found in practice that if substrates of a board size shorter than the intended board size are electroplated in the bath, the lower edges of the substrates will be "over-plated". This is known as "edging effect" and means that the metal deposited on or around the lower edges of the substrates is thicker than that deposited in the rest of the substrates.

While it is possible to reduce this "edging effect" by changing the anodes used in each electroplating task, as there may be over forty anodes in a single tank, and they are very heavy, it is very difficult and not practical to replace anodes.

It is therefore an object of the present invention to provide an improved electroplating apparatus in which the aforesaid shortcoming is mitigated, or at least to provide a useful alternative to the trade.

According to the present invention, there is provided an apparatus for electroplating at least one substrate, comprising support means, anode means, at least one container, and blocking means, wherein said support means is adapted to support said substrate and be in an electrically conductive relationship therewith, wherein said container is adapted to contain said anode means, said support means and an electrolyte, and wherein, in operation, an electric field exists in said electrolyte between said support means and said anode means, characterized in that said blocking means is movable by and relative to said support means.

Suitably, said blocking means maybe made substantially of an electrically insulating material.

Said insulating material may advantageously be poly-tetrafluoroethylene.

Said blocking means may conveniently comprise a plurality of sheet members.

Said sheet members may suitably be movable away from each other.

Advantageously, said blocking means may be elastic.

Conveniently, said blocking means may comprise a plurality of substantially rigid blocking members.

Suitably, said apparatus may comprise at least two plates to each of which at least one blocking member is hingedly engaged.

Said blocking members may advantageously be pivotally movable relative to the plate to which it is hingedly engaged.

Said blocking members may conveniently be made substantially of polypropylene.

The present invention will now be described by way of an example and with reference to the accompanying drawings, in which:-
Fig. 1 is a schematic diagram showing a first embodiment of an electroplating apparatus according to the present invention in which the trough is loaded with a substrate of a vertical length of 45.72cm (18 inches);
Fig. 2 is a side view of a polypropylene diaphragm used in the present invention;
Fig. 3 is a schematic diagram of the electroplating apparatus shown in Fig. 1 in which the trough is loaded with a substrate of a vertical length of 53.34cm (21 inches);
Fig. 4 is a schematic diagram of the electroplating apparatus shown in Fig. 1 in which the trough is loaded with a substrate of a vertical length of 60.96cm (24 inches);
Fig. 5 is a schematic diagram showing a second embodiment of an electroplating apparatus according to the present invention in which the trough is loaded with a substrate of a vertical length of 45.72cm (18 inches);
Fig. 6 is a schematic diagram of the electroplating apparatus shown in Fig. 5 in which the trough is loaded with a substrate of a vertical length of 53.34cm (21 inches);
Fig. 7 is a schematic diagram of the electroplating apparatus shown in Fig. 5 in which the trough is loaded with a substrate of a vertical length of 60.96cm (24 inches);
Figs. 8A and 8B are respectively a side view and an end view of a side plate used in the electroplating apparatus shown in Fig. 5;
Figs. 9A and 9B are respectively a side view and an end view of a blocking plate used in the electroplating apparatus shown in Fig. 5; and
Fig. 10 is a perspective view showing the engagement between the side plate and the blocking plates in the electroplating apparatus shown in Fig. 5.

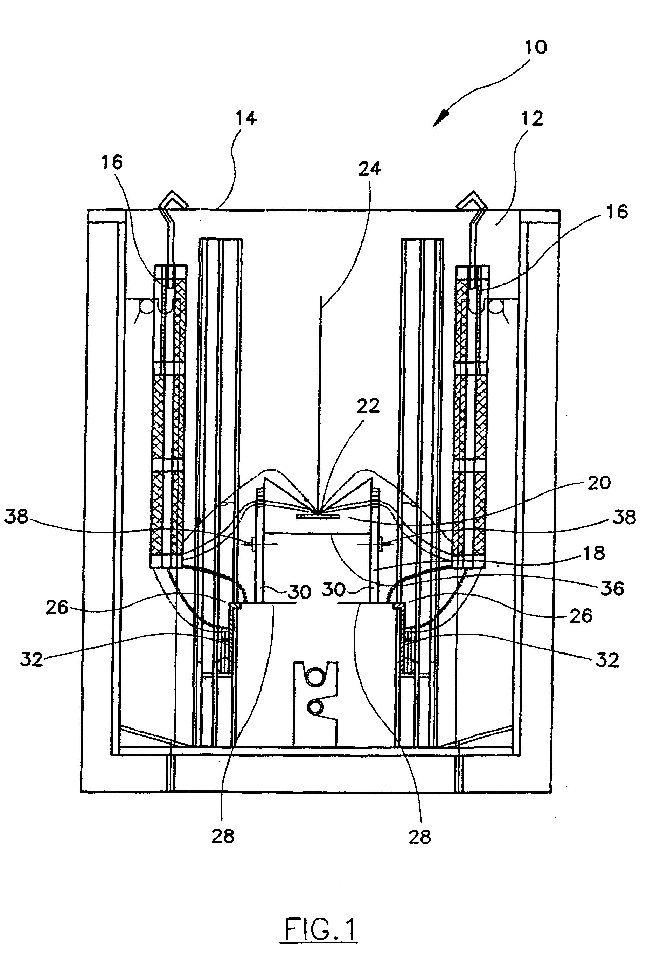

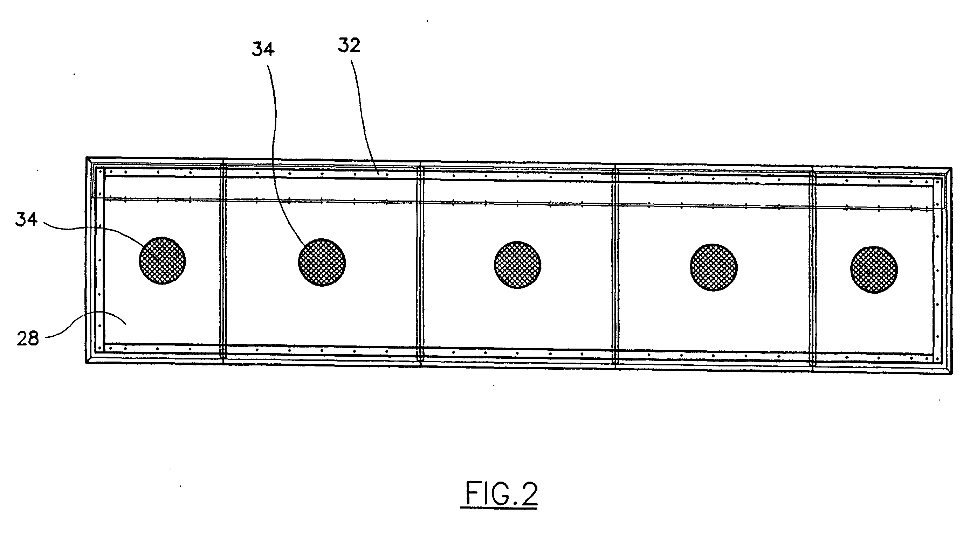

As shown in Fig. 1, a first embodiment of an electroplating apparatus according to the present invention is designated generally as 10. The electroplating apparatus 10 includes a bath 12 for containing an electrolyte which, for clarity purposes, is not shown in any of these drawings. Depending from an upper edge 14 of the bath 12 are two rows of anodes 16, of which only two are shown here. Within the bath 12 is a trough 18, which may be lowered into the bath 12 or raised therefrom. The trough 18 includes a number of receiving plates 20, only one of which is shown here. Each receiving plate 20 includes a V-shaped notch in which a lower edge 22 of a substrate 24 is to be plated, e.g. a printed circuit board, may be received, so that the substrate 24 is held in a substantially vertical plane. In Fig. 1, the vertical length of the substrate 24 is 45.72cm (18 inches). On either side of the trough 18 is an electrically insulating polypropylene diaphragm 26, details of which are shown in Fig. 2 and to be discussed below. Attached to each of the polypropylene diaphragms 26 is an elastic and electrically insulating poly-tetrafluoroethylene sheet 28 which extends across the length of the bath 12. The poly-tetrafluoroethylene 28 sheets assume a generally horizontal configuration in the bath 12. The poly-tetrafluoroethylene sheets 28 are of a thickness of about 0.5mm.

The trough 18 includes two side boards 30 which, when substrates 24 of a vertical length of 45.72cm (18 inches) are loaded into the receiving plates 20, just contact and bear on the upper surface of the poly-tetrafluoroethylene sheets 28.

Turning to Fig. 2, a polypropylene diaphragm 26 is shown as including an outer impermeable electrically insulating polypropylene frame 32, with a perforated cloth 34 made of electrically insulating polypropylene mesh material stretched across the inner open area. In this figure, for clarity purposes, only some areas (the five circular areas) of the cloth 34 are shown as perforated. It should however be understood that the whole cloth 34 is perforated. It is apparent that, with such an arrangement, while an electric field can exist across the perforated cloth 34, no electric field can exist across the polypropylene frame 32. The polypropylene diaphragm 26 effectively divides the bath 12 into a central "cathode compartment" and two outer "anode compartments". The holes in the perforated cloth 34 are so sized as to prevent particles such as anode sludge from passing into the central "cathode compartment", while allowing free movement of the electrolyte therethrough.

As can be seen in Fig. 1, although an electric field (as denoted by the hashed lines) can exist across the polypropylene diaphragm 26, no electric current can pass from under the bottom part 36 of the trough 18 since such is blocked by the poly-tetrafluoroethylene sheets 28 and/or the polypropylene frame 32. Since the amount of electric current reaching the lower end of the substrate 24 is reduced, less metal will be deposited in this area, thus reducing the "edging effect".

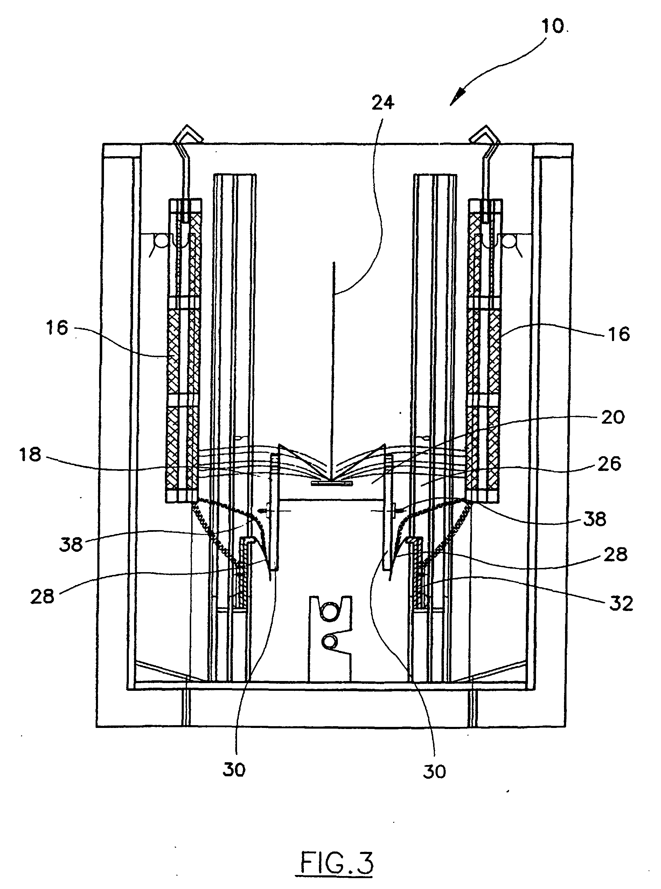

Turning to Fig. 3, the same electroplating apparatus 10 according to the present invention is shown. The substrate 24 received by the receiving plate 20 of the trough 18 is now of a vertical length of 53.34 cm (21 inches). It can be seen that while some electric current passes between the anodes 16 and the lower part of the substrate 24, part of the current is blocked by the impermeable electrically insulating polypropylene frame 32 of the polypropylene diaphragm 26. It can also be seen that when the trough 18 is lowered into the bath 12, the side plates 30 push the poly-tetrafluoroethylene sheets 28 away from each other. Due to their elasticity, when the trough 18 is raised from the bath 12, e.g. after plating, the poly-tetrafluoroethylene sheets 28 will resume their position as shown in Fig. 1. As shown in Fig. 3, the side boards 30 are in contact with the poly-tetrafluoroethylene sheets 28, so that there are no gaps between the side boards 30 and the poly-tetrafluoroethylene sheets 28 through which electric current can pass through. However, as compared with the situation in Fig. 1, more electricity passes between the anodes 16 and the lower part of the substrate 24.

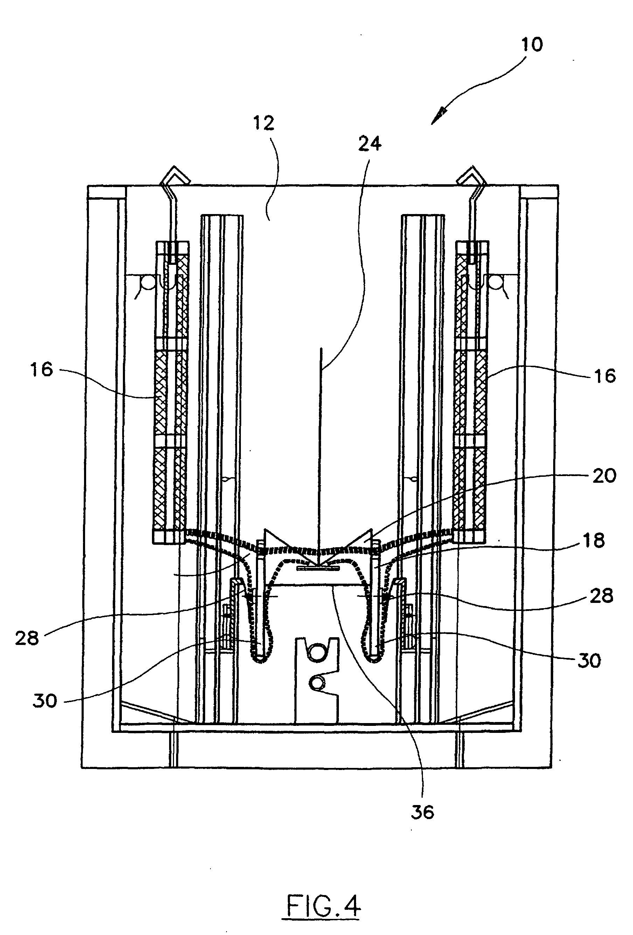

As to Fig. 4, again, the same electroplating apparatus 10 according to the present invention is shown. The substrate 24 received by the receiving plate 20 of the trough 18 is now of a vertical length of 60.96cm (24 inches). It can be seen that the trough 18 is much nearer to the bottom of the bath 12. As the trough 18 is lowered further towards the bottom of the bath 12, two rows of fingers (38 shown in Fig. 3, only two of which are shown here for clarity purposes) of the trough 18 push the poly-tetrafluoroethylene sheets 28 further away from each other, so that gaps exist between the side boards 30 and the poly-tetrafluoroethylene sheets 28. As shown clearly in Fig. 4, more electric current can pass between the anodes 16 and bottom part 36 of the trough 18.

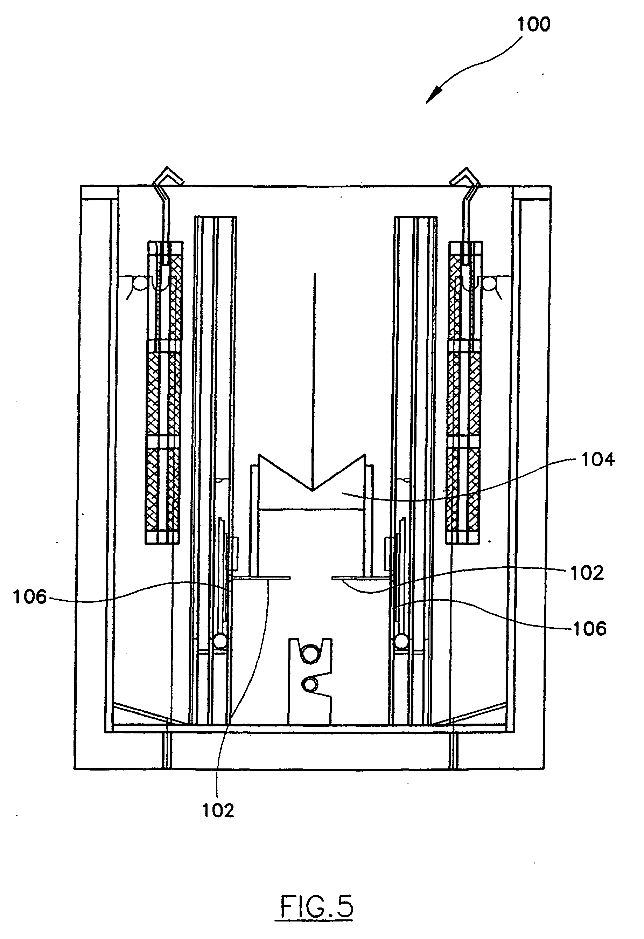

A second embodiment of an electroplating apparatus is shown in Fig. 5 as generally designated as 100. The structure of the electroplating apparatus 100 is essentially the same as that in the electroplating apparatus 10 shown in Figs. 1 to 4, except that the elastic poly-tetrafluoroethylene sheets 28 are replaced by a number of rigid electrically insulating blocking plates 102 which are made of polypropylene, the structure of which will be discussed below.

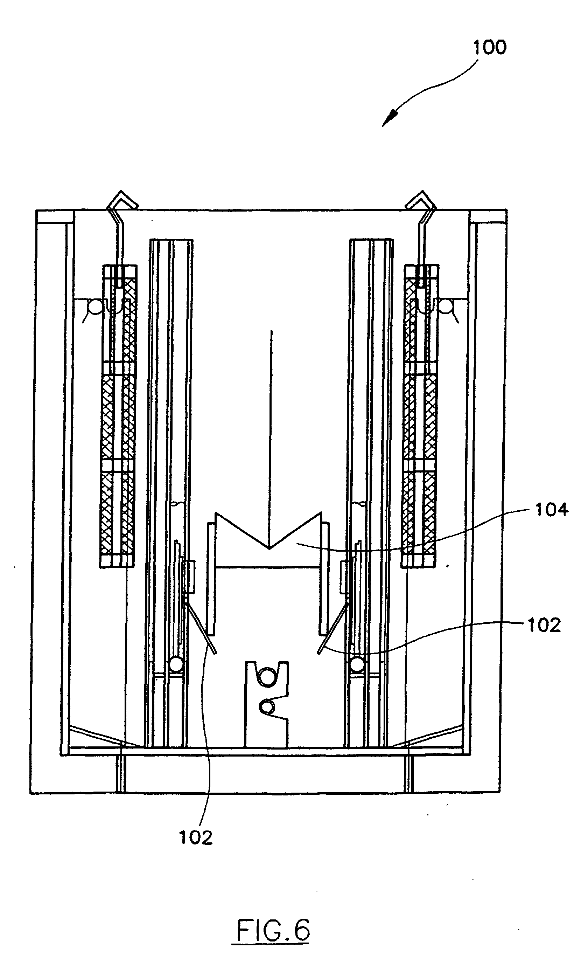

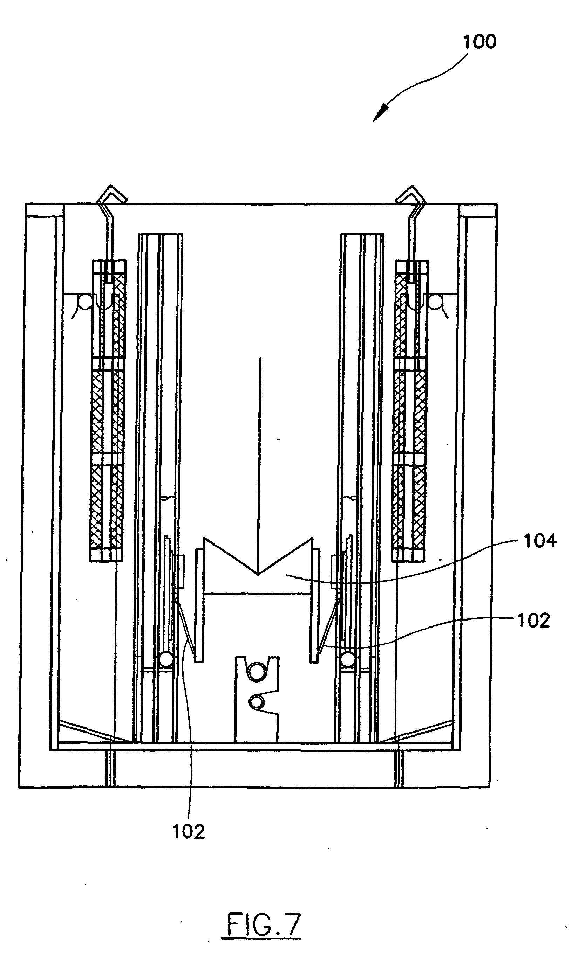

As shown in Figs. 5 to 7, the blocking plates 102 operate in essentially the same way as the elastic poly-tetrafluoroethylene sheets 28, and can be pushed away from each other when a trough 104 is immersed downward. The density of the blocking plates 102 is such that they will float and assume the position as shown in Fig. 5 in the electrolyte unless they are acted upon by the trough 104.

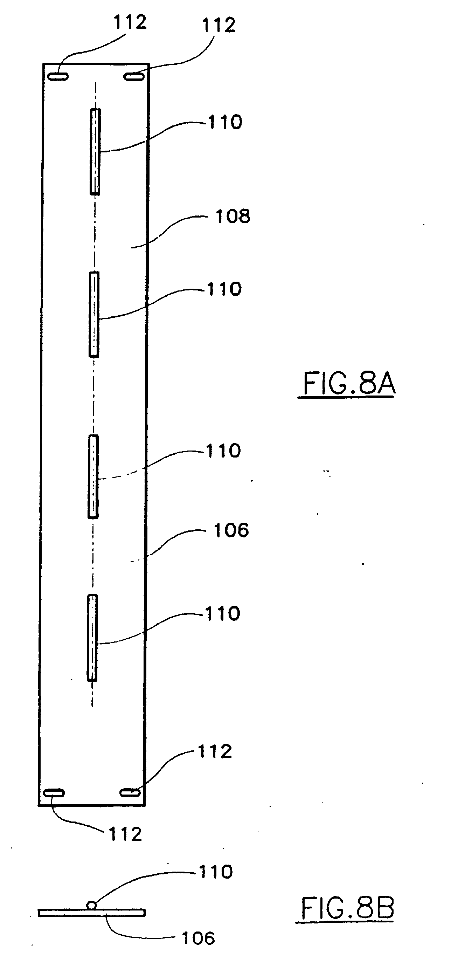

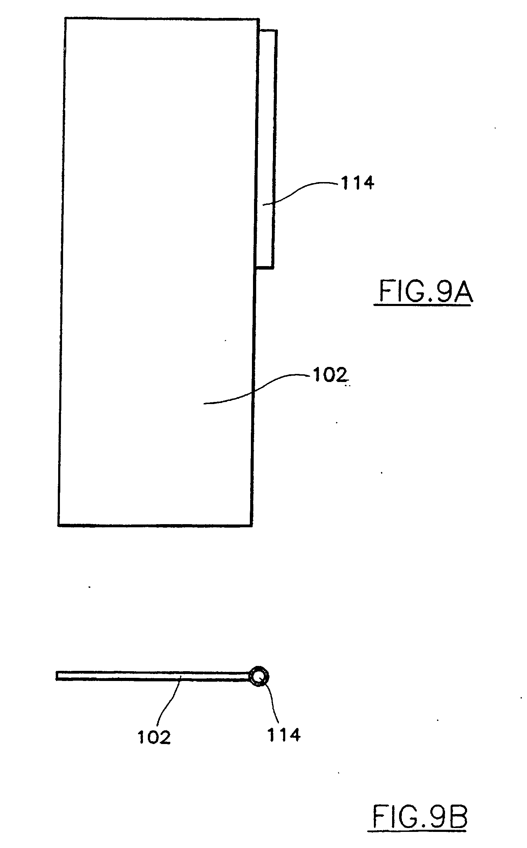

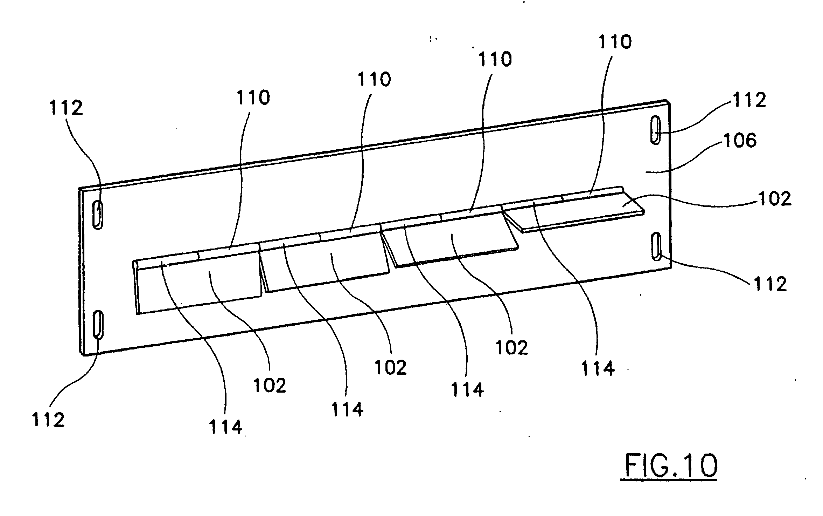

Figs. 8A and 8B show a side plate 106 with which the blocking plates 102 may be engaged. The side plate 106 includes a back plate 108 fixed with four rods 110. The side plate 106 includes four holes 112 for enhancing securing thereof to the apparatus 100. Figs. 9A and 9B show the blocking plate 102 as also including a rod 114. As shown in Fig. 10, the rod 114 of each of the blocking plates 102 may be engaged with one of the rods 110 so as to enable the blocking plates 102 to pivot relative to the side plate 106 when acted upon by the trough 104.

From the foregoing discussion, it can be clearly seen that the performance of an electroplating apparatus according to the present invention is versatile and flexible, and can provide satisfactory plating performance of substrates over a wide range of board sizes.

## Claims

1. An apparatus (10, 100) for electroplating at least one substrate (24), comprising support means (18, 104), anode means (16), at least one container (24), and blocking means (28, 102), wherein said support means is adapted to support said substrate and be in an electrically conductive relationship therewith, wherein said container is adapted to contain said anode means, said support means and an electrolyte, and wherein, in operation, an electric field exists in said electrolyte between said support means and said anode means, **characterized in that** said blocking means is movable by and relative to said support means.

2. An apparatus according to Claim 1 wherein said blocking means is made substantially of an electrically insulating material.

3. An apparatus according to Claim 2 wherein said insulating material is poly-tetrafluoroethylene.

4. An apparatus according to any of the preceding claims wherein said blocking means comprises a plurality of sheet members.

5. An apparatus according to any of the preceding claims wherein said sheet members are movable away from each other.

6. An apparatus according to any of the preceding claims wherein said blocking means is elastic.

7. An apparatus according to Claim 1 to 2 wherein said blocking means comprises a plurality of substantially rigid blocking members.

8. An apparatus according to Claim 7 wherein said apparatus comprises at least two plates (106) to each of which at least one blocking member is hingedly engaged.

9. An apparatus according to Claim 8 wherein each of said blocking members is pivotally movable relative to the plate to which it is hingedly engaged.

10. An apparatus according to any one of Claims 7 to 9 wherein said blocking members are made substantially of polypropylene.

## Patentansprüche

1. Vorrichtung (10, 100) zum Elektroplattieren wenigstens eines Substrats (24), mit einer Halteeinrichtung (18, 104), einer Anodeneinrichtung (16), wenigstens einem Behälter (12) und einer Blockiereinrichtung (28, 102), wobei die Halteeinrichtung so ausgelegt ist, daß sie das Substrat hält und mit ihm in einer elektrischen leitenden Beziehung ist, wobei der Behälter so ausgelegt ist, daß er die Anodeneinrichtung, die Halteeinrichtung und einen Elektrolyten enthält und wobei im Betrieb ein elektrisches Feld in dem Elektrolyten zwischen der Halteeinrichtung und der Anodeneinrichtung vorliegt, **dadurch gekennzeichnet, daß** die Blokkiereinrichtung mittels und relativ zu der Halteeinrichtung bewegbar ist.

2. Vorrichtung nach Anspruch 1, bei der die Blockiereinrichtung im wesentlichen aus einem elektrisch isolierenden Material hergestellt ist.

3. Vorrichtung nach Anspruch 2, bei der das isolierende Material Polytetrafluorethylen ist.

4. Vorrichtung nach einem der vorangehenden Ansprüche, bei der die Blockiereinrichtung eine Vielzahl von Lamellenelementen aufweist.

5. Vorrichtung nach einem der vorangehenden Ansprüche, bei der die Lamellenelemente voneinander weg bewegbar sind.

6. Vorrichtung nach einem der vorangehenden Ansprüche, bei der die Blockiereinrichtung elastisch ist.

7. Vorrichtung nach Anspruch 1 bis 2, bei der die Blockiereinrichtung eine Vielzahl von im wesentlichen starren Blockierelementen aufweist.

8. Vorrichtung nach Anspruch 7, bei der die Vorrichtung wenigstens zwei Platten (106) aufweist, wobei an jeder wenigstens ein Blockierelement gelenkig aufgehängt ist.

9. Vorrichtung nach Anspruch 8, bei der jedes der Blockierelemente relativ zu der Platte, an der es gelenkig aufgehängt ist, schwenkbar ist.

10. Vorrichtung nach einem der Ansprüche 7 bis 9, bei der die Blockierelemente im wesentlichen aus Polypropylen hergestellt sind.

## Revendications

1. Appareil (10, 100) de galvanoplastie pour au moins un substrat (24), comprenant un moyen de support (18, 104), un moyen d'anode (16), au moins un bac (24) et un moyen de blocage (28, 102), dans lequel ledit moyen de support est adapté pour supporter ledit substrat et être en contact avec celui-ci de manière conductrice, dans lequel ledit bac est adapté pour contenir ledit moyen d'anode, ledit moyen de support et un électrolyte, et dans lequel il existe, en fonctionnement, un champ électrique dans ledit électrolyte entre ledit moyen de support et ledit moyen d'anode, **caractérisé en ce que** ledit moyen de blocage est mobile par le biais dudit moyen de support relativement à celui-ci.

2. Appareil selon la revendication 1, dans lequel ledit moyen de blocage se compose essentiellement d'un matériau électriquement isolant.

3. Appareil selon la revendication 2, dans lequel ledit matériau isolant est du polytétrafluoroéthylène.

4. Appareil selon l'une quelconque des revendications précédentes, dans lequel ledit moyen de blocage comprend une pluralité d'éléments de feuilles.

5. Appareil selon l'une quelconque des revendications précédentes, dans lequel lesdits éléments de feuilles sont mobiles les uns par rapport aux autres.

6. Appareil selon l'une quelconque des revendications précédentes, dans lequel ledit moyen de blocage est élastique.

7. Appareil selon les revendications 1 et 2, dans lequel ledit moyen de blocage comprend une pluralité d'éléments de blocage essentiellement rigides.

8. Appareil selon la revendication 7, comprenant au moins deux plaques (106) sur chacune desquelles s'engage de manière articulée au moins un élément de blocage.

9. Appareil selon la revendication 8, dans lequel chacun desdits éléments de blocage est mobile et peut pivoter relativement à la plaque sur laquelle il s'engage de manière articulée.

10. Appareil selon l'une quelconque des revendications 7 à 9, dans lequel lesdits éléments de blocage se composent essentiellement de polypropylène.
